(19) Europäisches Patentamt
European Patent Office
Office européen des brevets

(11) **EP 1 509 780 B1**

(12) **EUROPÄISCHE PATENTSCHRIFT**

(45) Veröffentlichungstag und Bekanntmachung des Hinweises auf die Patenterteilung:
**11.01.2012   Patentblatt 2012/02**

(21) Anmeldenummer: 03730144.7

(22) Anmeldetag: **30.05.2003**

(51) Int Cl.:
*G01R 33/38* (2006.01)

(86) Internationale Anmeldenummer:
**PCT/EP2003/005714**

(87) Internationale Veröffentlichungsnummer:
**WO 2003/102617 (11.12.2003 Gazette 2003/50)**

(54) **BILDGEBENDES NMR-VERFAHREN SOWIE NMR-VORRICHTUNG**

NMR Imaging Method and Device

Procédé et appareil d'imagerie par RMN

(84) Benannte Vertragsstaaten:
**AT BE BG CH CY CZ DE DK EE ES FI FR GB GR HU IE IT LI LU MC NL PT RO SE SI SK TR**

(30) Priorität: **31.05.2002   DE 10224192**

(43) Veröffentlichungstag der Anmeldung:
**02.03.2005   Patentblatt 2005/09**

(73) Patentinhaber: **Fraunhofer-Gesellschaft zur Förderung der angewandten Forschung e.V.
80686 München (DE)**

(72) Erfinder:
• **VOLKE, Frank
66386 St. Ingbert (DE)**
• **BENECKE, Martin
66424 Homburg (DE)**

(74) Vertreter: **Rösler, Uwe
Rösler Patentanwaltskanzlei
Landsberger Strasse 480a
81241 München (DE)**

(56) Entgegenhaltungen:
**EP-A- 0 230 027      EP-A- 0 512 345
EP-A2- 0 927 889      WO-A-00/34792
WO-A1-00/57435      US-B1- 6 281 775**

• **M.J.D. MALLETT ET AL.: "Stray Field Imaging by Magnetic Field Sweep" JOURNAL OF MAGNETIC RESONANCE, Bd. 132, 1998, Seiten 172-175, XP002254738 ISSN: 1090-7807 & WO 98 43103 A 1. Oktober 1998 (1998-10-01)**

Bemerkungen:
Die Akte enthält technische Angaben, die nach dem Eingang der Anmeldung eingereicht wurden und die nicht in dieser Patentschrift enthalten sind.

EP 1 509 780 B1

## Beschreibung

### Technisches Gebiet

Die Erfindung bezieht sich auf ein bildgebendes NMR-Verfahren, bei dem ein zu untersuchendes Objekt einem stationären magnetischen Polarisationsfeld $B_0$ sowie einem elektromagnetischen Wechselfeld ausgesetzt wird und im Objekt kernresonante Prozesse induziert werden, die als Messsignale erfasst und visuell dargestellt werden. Ferner wird eine NMR-Vorrichtung beschrieben.

### Stand der Technik

NMR-bildgebende Verfahren sowie auch entsprechende Vorrichtungen dienen u.a. zur zerstörungsfreien Material- und Strukturuntersuchung von Objekten, die aus kristallinen, glasigen Werkstoffen oder aus weichen Materialien, wie beispielsweise Elastomere, oder Flüssigkeiten oder aus biologischen Materialien bestehen können.

Ein bekanntes NMR-Verfahren sowie auch eine diesbezügliche Vorrichtung ist der DE 199 39 626 A1 zu entnehmen, in der unter Bezugnahme auf die Fig. 3a und 3b eine transportable NMR-Vorrichtung beschrieben ist. Die bekannte Vorrichtung sieht zwei voneinander beabstandet angeordnete Permanentmagnete vor, die der Erzeugung eines stationären magnetischen Polarisationsfeldes dienen. Zwischen den Permanentmagneten sind eine HF-Spulenanordnung sowie zwei Gradientenspulen vorgesehen, letztere dienen zur Erzeugung eines, das stationäre magnetische Polarisationsfeld überlagernden magnetischen Gradientenfeldes, das zur ortsaufgelösten NMR-Messung in zeitlichen Abständen gepulst betrieben wird.

Mit Hilfe der HF-Spulenanordnung, die neben der Erzeugung des HF-Wechselfeldes zugleich auch als Empfangsspule dient, werden hochfrequente Signale, die durch im Inneren der Probe auftretende kernresonante Prozesse hervorgerufen werden, empfangen und mittels einer Auswerteeinheit zur bildlichen Darstellung gebracht. Die im Inneren der Probe auftretenden kernresonanten Prozesse sind überwiegend auf Kernspin-Wechselwirkungen der Wasserstoffatome mit dem stationären magnetischen Polarisationsfeld zurückzuführen, die auf einer gezielten energetischen HF-Anregung durch das HF-Wechselfeld beruhen, und können in der Auswertung im weitläufigsten Sinne mit der innerhalb des untersuchten Probenvolumens vorhandenen Wasserstoffkonzentration ins Verhältnis gebracht werden.

Zwar erlaubt die vorstehend beschriebene NMR-Vorrichtung in Ausbildung eines transportablen Gerätes eine flächenhafte Untersuchung eines Objektes durch Überstreifen der Objektoberfläche, doch ist das zu analysierbare Objektvolumen durch die nur sehr geringe Eindringtiefe der durch die NMR-Vorrichtung erzeugbaren Magnetfelder auf nur wenige Millimeter beschränkt.

Sicherlich ist es möglich, durch entsprechende Größerdimensionierung der eingesetzten Permanentmagnete die Eindringtiefe in das zu untersuchende Objekt zu verbessern, doch vermögen derartige Skalierungsmaßnahmen die tatsächliche magnetische Durchdringungstiefe nur unwesentlich zu beeinflussen. Darüber hinaus wird die NMR-Vorrichtung durch größere und damit schwerere Permanentmagnete für den portablen Einsatz unbrauchbar.

Ferner erfordert das vorstehend beschriebene NMR-System zur ortsaufgelösten NMR-Analyse Gradientenspulen zur Erzeugung magnetischer Gradientenfelder, die eine aufwendige Ansteuerung und damit verbunden eine technisch aufwendige Gewinnung der Messsignale bedingen.

Um den apparativen Aufwand von NMR-Anlagen zu reduzieren wird in der DE 36 39 140 A1 vorgeschlagen den Raumbereich des stationären magnetischen Polarisationsfeldes zu reduzieren, wodurch jedoch ein zu untersuchender Patient nicht gesamtheitlich, sondern lediglich in einem Teilbereich von diesem Magnetfeld durchdrungen wird. Das stationäre magnetische Polarisationsfeld wird mit Hilfe einer Doppelmagnetanordnung nach Helmholtz erzeugt, wodurch zwischen der Magnetanordnung eine taillierte Magnetfeldlinienbündelung mit erhöhter Magnetflußdichte hervorgerufen wird. In diesem taillierten Magnetfeldlinienbereich wird der zu untersuchende Patient positioniert. Um den Patienten gesamtheitlich zu untersuchen ist eine bewegliche Lagerung des Patienten relativ zur Magnetanordnung vorgesehen. Auch in diesem Fall sieht das in dieser Druckschrift beschriebene magnetische Resonanzsystem eine Gradientenspulenanordnung zur Ortsauflösung von Messpunkten innerhalb des taillierten Magnetfeldlinienbereiches vor.

Eine zum vorstehenden magnetischen Resonanzsystem vergleichbare Magnetanordnung ist der EP 0 228 154 A2 zu entnehmen, die eine zu NMR-Zwecken geeignete Doppelmagnetanordnung zeigt. Um die magnetischen Verluste durch sogenannte Magnetfeldleckagen zu reduzieren, weisen die Magnetanordnungen jeweils eine konkavartig ausgebildete, einander zugewandte Oberseite auf, wodurch die Magnetlinien ebenfalls eine taillierte Feldform zwischen den Magnetanordnungen annehmen. Auch in diesem Falle sind jedoch zusätzliche Gradientenfelder erforderlich, um eine Ortsauflösung bei Probenuntersuchungen zu ermöglichen.

Die US 6,281,775 B1 zeigt eine für NMR-Anlagen geeignete Permanentmagnetanordnung aus zwei einen Zwischenraum einschließenden Magnetanordnungen, mit der ein möglichst homogenes Magnetfeld im Untersuchungsbereich erzeugt werden kann. Hierzu weisen die Magnetanordnungen verstellbare ring- oder scheibenförmige oder kreisförmig angeordnete Einzelmagnete auf.

In dem Beitrag von M.J.D. Mallett et al.: Stray Field Imaging by Magnetic Field Sweep", J.Mag.Res., 132 (1998), 172-175" wird eine Variante eines Kernres-

onanz-Verfahrens, das so genannte STRAFI-Verfahren (Stray Field Magnetic Resonance Imaging) zur Materialuntersuchung beschrieben. Hierbei befindet sich das Untersuchungsobjekt außerhalb der Hauptmagnetfeldanordnung, wo ein starkes magnetisches Gradientenfeld vorherrscht. In genau einer "sensitiven" Schicht des Untersuchungsobjekts, d.h. in einer Ebene senkrecht zu den Magnetfeldlinien, die einen definierten Abstand von der Stirnfläche der Hauptmagnetfeldanordnung besitzt, werden mittels Überlagerten mit einem elektromagnetischen Wechselfeld kernresonante Prozesse induziert. Üblich ist es, das Untersuchungsobjekt durch diese Ebene zu bewegen. In dem Artikel werden zwei Verfahrensvarianten beschrieben, bei denen der Abstand dieser Ebene verändert werden kann, ohne dabei das Untersuchungsobjekt bewegen zu müssen.

Die WO 00/3479 beschreibt eine NMR-Apparatur, bei der sich das Magnetresonanzvolumen außerhalb der Hauptmagnetfeldanordnung in einem Gradientenfeld befindet. Das Hauptmagnetfeld wird durch mehrere konzentrisch angeordnete Hauptfeldspulen erzeugt. Innerhalb einer Schicht werden Kernresonanzbedingungen erzeugt, deren axialer Abstand zum Hauptmagneten ("sweet spot") verändert werden kann. Durch zusätzliche Shim-Spulen, die konzentrisch zueinander und axial von den Hauptmagnetfeldspulen beabstandet angeordnet sind, wird das Magnetfeld verändert, so dass sich die Schicht, in der die Kernresonanzbedingung erzeugt wird, möglichst eben und senkrecht zur Symmetrieachse des Magnetfeldes ausbildet. Zusätzlich kann die axiale Lage des "sweet spot" verändert werden.

Die EP 0 927 889 A2 zeigt eine NMR-Vorrichtung, bei der die Anordnung zur Erzeugung eines homogenen Magnetfelds, bestehend aus Permanentmagneten und dazugehörigen Shimming-Magneten, beweglich gelagert ist.

## Darstellung der Erfindung

Ausgehend von dem eingangs beschriebenen Stand der Technik besteht die Aufgabe, ein NMR-Verfahren sowie eine entsprechende Vorrichtung anzugeben, das eine weitaus größere magnetische Eindringtiefe in ein zu analysierendes Objekt gestattet und überdies eine transportable Verwendung der NMR-Vorrichtung ermöglicht. Zudem soll es möglich sein, eine ortsaufgelöste Messsignal-Gewinnung mit ungleich geringerem gerätetechnischen und messtechnischen Aufwand zu realisieren.

Die Lösung der der Erfindung zugrundeliegenden Aufgabe ist im Anspruch 1 angegeben, das ein bildgebendes NMR-Verfahren beschreibt. Gegenstand des Anspruches 6 ist eine erfindungsgemäße NMR-Vorrichtung. Den Erfindungsgedanken vorteilhaft weiterbildende Merkmale sind Gegenstand der Unteransprüche.

Ein gattungsgemäßes bildgebendes NMR-Verfahren umfasst ein Verfahren, bei dem ein zu untersuchendes Objekt (O) einem stationären magnetischen Polarisationsfeld $B_0$ sowie einem elektromagnetischen Wechselfeld ausgesetzt wird und im Objekt (O) kernresonante Prozesse induziert werden, die als Messsignale erfasst und visuell dargestellt werden, wobei das stationäre magnetische Polarisationsfeld durch eine Vielzahl einzelner Magneteinheiten erzeugt wird. Die magnetischen Polarisationsfelder der einzelnen Magneteinheiten überlagern sich durch Superposition in wenigstens einem räumlich begrenzten Volumenbereich (4) innerhalb des Objektes (O) derart, dass in dem räumlich begrenzten Volumenbereich (4) eine größere magnetische Flussdichte vorherrscht als im übrigen Bereich des Objektes (O). Dabei werden die innerhalb des räumlich begrenzten Volumenbereiches (4) vorherrschende magnetische Flussdichte sowie die Frequenz des in dem räumlich begrenzten Volumenbereich (4) wirkenden elektromagnetische Wechselfeldes derart aufeinander abgestimmt, dass ausschließlich innerhalb des räumlich begrenzten Volumenbereiches (4) kernresonante Prozesse induziert werden. Die räumliche Lage des räumlich begrenzten Volumenbereiches (4) wird mit Hilfe der das stationäre magnetische Polarisationsfeld konzentrierenden Superposition bestimmt und die zu dem räumlich begrenzten Volumenbereich (4) korrespondierenden Messsignale werden erfasst. Die räumliche Lage des räumlich begrenzten Volumenbereiches (4) wird durch räumliche Lageänderung der einzelnen Magneteinheiten wenigstens einmal kontrolliert geändert und die Messsignale werden jeweils erneut aus dem räumlich geänderten räumlich begrenzten Volumenbereich (4) erfasst. Erfindungsgemäß ist ein gattungsgemäßes, bildgebendes NMR-Verfahren gemäß dem Oberbegriff des Anspruches 1 derart ausgebildet, dass die einzelnen Magneteinheiten auf der Konkavseite einer parabolisch geformten Fläche angeordnet werden, wobei die räumliche Position des Volumenbereiches sich im Fokuspunkt der parabolisch geformten Fläche befindet, und dass über Stellglieder sequentiell ein Krümmungsverhalten der parabolisch geformten Fläche und die Fokuspunktlage und somit die räumliche Lage des Volumenbereiches geändert wird.

Innerhalb des räumlich begrenzten Volumenbereiches werden kernresonante Prozesse induziert, wodurch Messsignale lokal hervorgerufen werden, die mit Hilfe einer Empfangseinheit erfasst werden. Die in dem räumlich begrenzten Volumenbereich erzeugten Feldbedingungen sorgen ausschließlich in dem räumlich abgrenzbaren Volumenbreich für die Induzierung der kemresonanten Prozesse, außerhalb des räumlich begrenzten Volumenbereiches treten hingegen keinerlei derartige Prozesse auf oder zumindest nicht in einem messtechnisch erfassbaren Umfang. Zudem werden die zu dem räumlich begrenzten Volumenbereich korrespondierenden Messsignale mit Informationen über die räumliche Lage des räumlich begrenzten Volumenbereiches ergänzt. In einem weiteren Schritt wird die räumliche Lage des räumlich begrenzten Volumenbereiches relativ zu dem ansonsten ruhenden Objekt geändert und anschließend erneut Messsignale aus dem räumlich geänderten räumlich begrenzten Volumenbereich erfasst. Die Lageänderung erfolgt in kontrollierter Weise, so dass stets sichergestellt ist, dass eine räumliche Lagebestimmung der jeweiligen vermessenen Volumenbereiche möglich ist. Die Lageänderung des vermessenen Volumenbereiches wird beliebig oft wiederholt, bis beispielsweise das gesamte Objektvolumen messtechnisch erfasst ist und eine Rekonstruktion des Gesamtobjektes aus der Vielzahl der Einzelmessungen möglich ist. Selbstverständlich kann sich die Objektvermessung auch nur auf die Erfassung von Einzelteilbereichen beschränken.

Der Vorteil des erfindungsgemäßen Verfahrens ist vornehmlich darin zu sehen, dass das gesamte zu vermessende Objektvolumen in sequentiell hintereinander durchzuführenden NMR-Einzelmessschritten vermessen und analysiert wird, wobei in jedem einzelnen Messschritt die für eine erfolgreiche NMR-Messung erforderlichen Messbedingungen lediglich in einem räumlich eng begrenzten Volumenbereich herzustellen sind, innerhalb dem die für die kemresonanten Prozesse erforderlichen energetischen Bedingungen in Bezug auf magnetische Flussdichte sowie Resonanzfrequenz des HF-Feldes erfüllt sein müssen. Mit anderen Worten werden, anders als bisher, nicht im gesamten Wirkbereich des statischen magnetischen Polarisationsfeld kernresonante Prozessbedingungen hergestellt, sondern lediglich in einem eng begrenzten Volumenbereich, einem sogenannten Voxel. Dies hat zudem den Vorteil, dass durch die räumliche Konzentration der Magnetfeldlinien innerhalb eines Volumenbereiches bei gleichem energetischen Aufwand verglichen zu bekannten Verfahren, eine ungleich größere messtechnisch erfassbare Eindringtiefe in ein zu untersuchendes Objekt erzielt werden kann.

Im Unterschied zu bekannten Magnetanordnungen, mit denen es nicht möglich ist, die Magentfeldlinien auf einen räumlich begrenzten, d.h. räumlich abgeschlossenen Volumenbereich zu konzentrieren, sieht das erfindungsgemäße Verfahren eine gezielte Magnetfedlinienkonzentration auf einen räumlich vollständig begrenzbaren Raumbereich vor, dessen räumliche Lage bereits mit Hilfe der Konzentrationstechnik bestimmbar ist, ohne den Einsatz zusätzlicher Gradientenfelder.

Wird beispielsweise zur kemspinresonanten Anregung das HF-Feld als gegeben bzw. als konstant vorausgesetzt, so gilt es zur Erfüllung der sogenannten Larmor-Frequenz-Bedingung, bei der Resonanzabsorption unter den Spin-ausgerichteten Atomkerne relativ zum stationären magnetischen Polarisationsfeld auftritt, die magnetische Flussdichte innerhalb des räumlich begrenzten Volumenbereiches in bestimmter Weise zu wählen. Insbesondere gilt für die Resonanzbedingung folgende Bedingung:

$$f = \frac{\gamma}{2\pi} \cdot |B|$$

mit f = Resonanzfrequenz des HF-Feldes, y = gyromagnetischer Faktor des Objektmaterials und B = magnetische Flussdichte.

Die magnetische Flussdichte innerhalb des räumlich begrenzten Volumenbereiches ist demzufolge derart zu wählen, dass innerhalb des Volumenbereiches die magnetische Flussdichte und somit das stationäre magnetische Polarisationsfeld $B_0$ der vorstehend genannten Resonanzbedingung entspricht. In allen übrigen Bereichen des Objektes herrscht eine geringere magnetische Flussdichte, so dass in diesen übrigen Objektbereichen keine oder keine nennenswerten kemresonanten Prozesse zu beobachten sind.

Das stationäre magnetische Polarisationsfeld wird durch Superposition einzelner magnetischer Polarisationsfelder erzeugt. Die gegenseitige räumliche Orientierung der vielen magnetischen Einzelfelder, die jeweils über untereinander gleichgerichtete Magnetfeldlinien verfügen, ist derart zueinander orientiert, dass sie sich in einem begrenzten Volumenbereich konstruktiv zur Ausbildung einer lokalen überhöhten magnetischen Flussdichte überlagern.

Die räumliche Position des Volumenbereiches wird verändert. Dies ist bei Verwendung einer Vielzahl von Einzelmagneteinheiten durch entsprechende räumliche Lageveränderung der einzelnen Magneteinheiten möglich. Erfindungsgemäß befinden sich hierzu die einzelnen Magneteinheiten auf der Konkavseite einer parabolisch geformten Fläche, der nach den Gesetzen der geometrischen Optik ein Fokuspunkt zuordenbar ist, in dem sich die einzelnen Magnetfelder konstruktiv überlagern. Beispielsweise durch Änderung des Krümmungsverhaltens der parabolisch geformten Fläche ändert sich die Fokuspunktlage und somit die räumliche Lage des Volumenbereiches. Durch gezielte sequentielle Lageveränderungen des Volumenbereiches ist auf diese Weise das gesamte Volumenbereich des Objektes messtechnisch zu erfassen. Unter Verwendung geeigneter Auswerteprogramme ist letztlich aus der Vielzahl einzeln messtechnisch erfasster Volumenbereiche durch Überlagerung bzw. Zusammenfügung ein Abbild des gesamten Objektes mosaiksteinartig herstellbar.

Neben der ungleich größeren Eindringtiefe, die mit der Superposition aus einer Vielzahl einzelner Magnetfelder innerhalb eines zu untersuchenden Objektes erzielbar ist oder durch entsprechende Fokussierung von Magnetfeldlinien, entfällt bei dem erfindungsgemäßen Verfahren die Notwendigkeit des Vorsehens magnetischer Gradientenfelder zur Ortsauflösung der Messsignale, zumal diese Ortsinformation bereits aus dem Superpositionsprinzip bzw. der magnetischen Fokussierung ableitbar ist. So lässt sich beispielsweise die räumliche Anordnung der Vielzahl einzelner Magneteinheiten mit geeigneten Stellgliedern in gewünschter Weise ändern, so dass sich die Lage des durch die Gesamtanordnung der Magneteinheiten bestimmten Fokuspunktes definiert ändert.

Derartige Stellglieder können in vielfacher Weise ausgebildet sein, beispielsweise als Piezo-Stellelemente oder als hydraulisch regelbare Stellglieder, mit denen beispielsweise die Form einer Trägermatrix, auf der die einzelnen Magneteinheiten aufgebracht sind, kontrolliert änderbar ist. Weiterhin können die Spulen in einer definierten Array-Anordnung auf der Trägermatrix gezielt für die Felderzeugung angesprochen bzw. aktiviert werden.

Mit Hilfe einer erfindungsgemäß ausgebildeten NMR-Vorrichtung ist es möglich, Volumenbereiche innerhalb eines Objektes selektiv auszuwählen und aus diesen Bereichen Messsignale zu erhalten, die zur lokalisierten Spektroskopie herangezogen werden können. Ferner sind zerstörungsfreie Material- als auch Qualitätskontrollen bzw. -analysen durchführbar. Durch eine programmierbare Abfolge zur Erfassung einzelner Volumenbereiche beispielsweise längs einer Zeile oder durch entsprechende Kombination einer Vielzahl derartiger Zeilen sind größere Volumina des Objektes messtechnisch erfassbar und bildlich darstellbar. Auch läßt das erfindungsgemäße Verfahren die Ausbildung einer NMR-Vorrichtung in Dimensionen zu, in denen das Gerät als transportable Einheit genutzt werden kann. Eine derartige NMR-Vorrichtung lässt sich für eine Vielzahl von Einsatzgebieten verwenden, bspw. für Untersuchungen von Materialien und Objekten aus der Biotechnologie, Land- und Forstwirtschaft, Baustoffkunde etc..

## Kurze Beschreibung der Erfindung

Die Erfindung wird nachstehend ohne Beschränkung des allgemeinen in Anspruch 1 und Anpruch 6 definierten Erfindungsgedankens anhand von Ausführungsbeispielen unter Bezugnahme auf die Zeichnungen exemplarisch beschrieben. Es zeigen:

    Fig. 1 schematisierte Darstellung einer NMR-Vorrichtung,
    Fig. 2 Detaildarstellung einer Anordnung von Magneteinheiten auf einem Paraboloid.

## Wege zur Ausführung der Erfindung, gewerbliche Verwendbarkeit

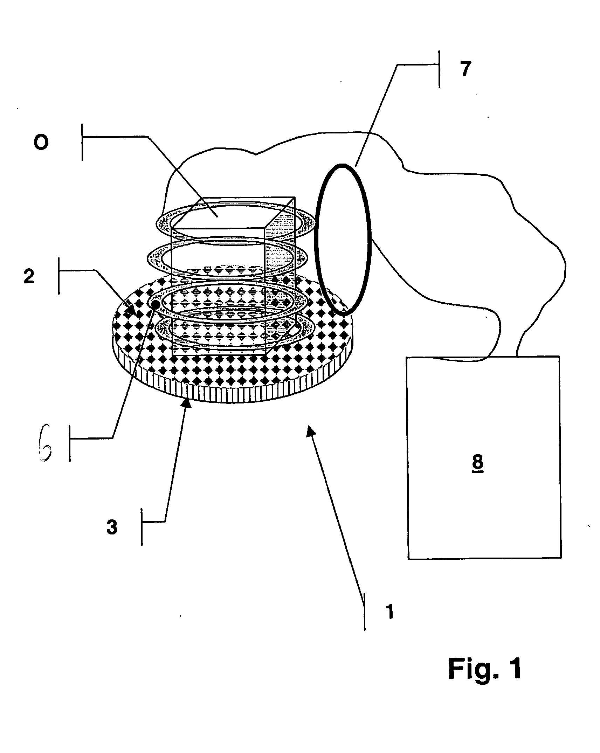

In Fig. 1 gilt es ein schematisiert dargestelltes Objekt O mit Hilfe eines kernspinresonanten Verfahrens zerstörungsfrei zu untersuchen. Hierzu bedarf es eines stationären magnetischen Polarisationsfeldes $B_0$, das mit einer Magnetfelderzeugenden Einheit 1 generiert wird.

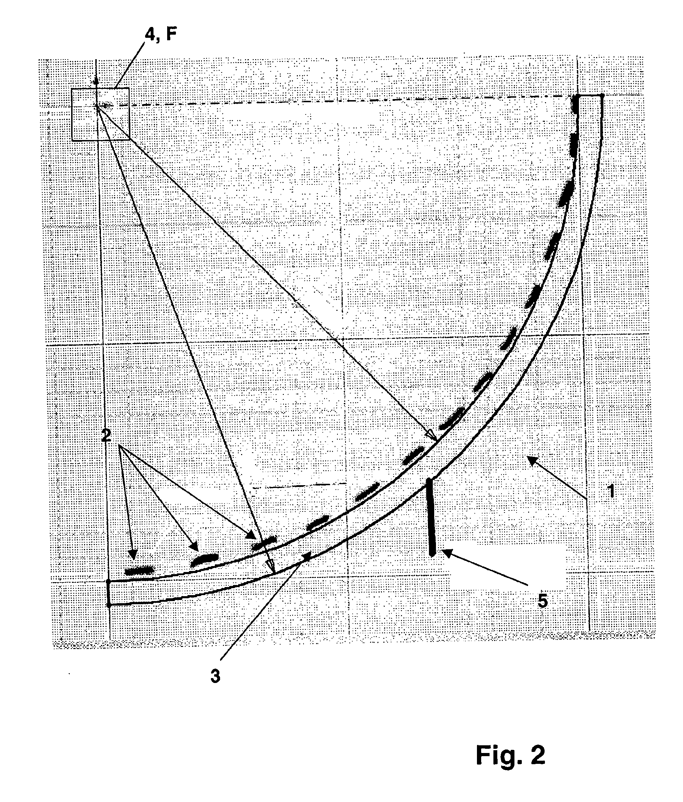

Im Ausführungsbeispiel gemäß Fig. 1 sei angenommen, dass die Magnetanordnung 1 eine Vielzahl einzelner Magneteinheiten 2 aufweist, die auf der Konkavseite einer parabolisch geformten Fläche 3, der sogenannten Trägermatrix, angeordnet sind (siehe hierzu Figur 2). Selbstverständlich ist es auch möglich die Trägermatrix in anderen Geometrieformen auszubilden, die ein fokales Abbildungsverhalten zeigen, bspw. sphärische oder zylindrische Flächenformen.

Durch die räumliche Ausbildung der parabolisch geformten Trägermatrix 3 überlagern sich die Magnetfelder der einzelnen Magneteinheiten 2 im Volumenbereich 4, der unter Annahme der Regeln aus der geometrischen Optik im Fokuspunkt F der parabolisch geformten Trägermatrix 3 angeordnet ist. Der als Voxel bezeichenbare Volumenbereich 4 weist Volumengrößen von bis hinab zu 1 $\mu$l auf, wodurch eine Ortsauflösung der Messungen bis hinab in den $\mu$m-Bereich geschaffen wird. Dies ist möglich durch die Verwendung in Überlagerung zu bringender Magnetfelder.

Durch entsprechende Veränderung der konkavseitigen Oberflächenkrümmung der Trägermatrix 3 verändert sich auch die räumliche Lage des Fokuspunktes F und damit des Volumenbereiches 4, indem sich durch Superposition die Magnetfelder der einzelnen magnetischen Einheiten 4 konstruktiv überlagern. Die Raumformänderung der Trägermatrix 3 erfolgt mit Hilfe eines Stellmittels 5, das in Form eines hydraulischen Aktuators ausgebildet ist. Ebenso ist es möglich, das Stellmittel 5 durch piezoelektrische Elemente zu realisieren.

Bezugnehmend auf das Ausführungsbeispiel gemäß Fig. 1 befindet sich das zu untersuchende Objekt O innerhalb jenes Raumbereiches, in dem der Volumenbereich 4 durch entsprechende Ansteuerung der Magnetanordnung 1 kontrolliert positionierbar ist. Zur Durchführung einer NMR-Untersuchung ist das Objekt O einem elektromagnetischen HF-Wechselfeld auszusetzen, das beispielsweise mit Hilfe einer geeigneten HF-Volumenspule 6 oder einer geeignet ausgebildeten Oberflächenspule 7 erzeugbar ist. Die in Abhängigkeit der räumlichen Lage des Volumenbereiches 4 innerhalb des Objektes O und den darin herrschenden Resonanzbedingungen (Larmor-Frequenz-Bedingung) generierbaren Messsignale werden ebenfalls über die das elektromagnetische HF-Wechselfeld erzeugende Spuleneinheit 6 bzw. 7 erfasst und mit Hilfe einer Empfängereinheit 8 entsprechend verstärkt, ausgewertet und letztlich auf einer bilderzeugenden Einheit visuell dargestellt.

Ebenso erfolgt die Ansteuerung der Lägeveränderung der einzelnen Magneteinheiten 2 mit Hilfe der Empfangseinheit 8, wodurch die räumliche Lage des Volumenbereiches 4 definiert ist.

Durch entsprechendes sequentielles Abscannen des Objektes O in der vorstehenden Weise ist es somit möglich, zerstörungsfrei das gesamte Volumen eines Objektes O zu erfassen und visuell darzustellen. Die erfindungsgemäße NMR-Vorrichtung ist vorzugsweise als portables System ausführbar und für den Feldeinsatz vor Ort einsetzbar. So ist es mit Hilfe der erfindungsgemäßen Vorrichtung erstmals möglich Gegenstände aller Art, gleichgültig ob es sich um Objekte aus der belebten oder unbelebten Natur handelt, vor Ort zu vermessen.

Bspw. ist es möglich das Innere eines Baumes durch Plazieren aller für die Messung erforderlichen Komponenten um den Baum herum, zu vermessen. Aufgrund des kleinen Messvolumens können überdies spektroskopische Untersuchungen am Messobjekt bspw. innerhalb eines Baumes durchgeführt werden.

**Bezugszeichenliste**

1    Magnetanordnung

2    Magneteinheiten

3    Fläche, Trägermatrix

4    Volumenbereich, Voxel

5    Stellelement

6    HF-Spule, Volumenspule

7    HF-Spule, Oberflächenspule

8    Empfangseinheit

**Patentansprüche**

**1.** Bildgebendes NMR-Verfahren, bei dem ein zu untersuchendes Objekt (O) einem stationären magnetischen Polarisationsfeld $B_0$ sowie einem elektromagnetischen Wechselfeld ausgesetzt wird und im Objekt (O) kernresonante Prozesse induziert werden, die als Messsignale erfasst und visuell dargestellt werden,
wobei das stationäre magnetische Polarisationsfeld durch eine Vielzahl einzelner Magneteinheiten erzeugt wird,
sich die magnetischen Polarisationsfelder der einzelnen Magneteinheiten durch Wobei Superposition in wenigstens einem räumlich begrenzten Volumenbereich (4) innerhalb des Objektes (O) derart überlagern, dass in dem räumlich begrenzten Volumenbereich (4) eine größere magnetische Flussdichte vorherrscht als im übrigen Bereich des Objektes (O),
wobei die innerhalb des räumlich begrenzten Volumenbereiches (4) vorherrschende magnetische Flussdichte sowie die Frequenz des in dem räumlich begrenzten Volumenbereich (4) wirkenden elektromagnetischer Wechselfeldes derart aufeinander abgestimmt werden, dass ausschließlich innerhalb des räumlich begrenzten Volumenbereiches (4) kernresonante Prozesse induziert werden,
wobei die räumliche Lage des räumlich begrenzten Volumenbereiches (4) mit Hilfe der das stationäre magnetische Polarisationsfeld konzentrierenden Superposition bestimmt und die zu dem räumlich begrenzten Volumenbereich (4) korrespondierenden Messsignale erfasst werden,
wobei die räumliche Lage des räumlich begrenzten Volumenbereiches (4) durch räumliche Lageänderung der einzelnen Magneteinheiten wenigstens einmal kontrolliert geändert wird und die Messsignale jeweils erneut aus dem räumlich geänderten räumlich begrenzten Volumenbereich (4) erfasst werden, **dadurch gekennzeichnet, dass** die einzelnen Magneteinheiten auf der Konkavseite einer parabolisch geformten Fläche angeordnet werden, wobei die räumliche Position des Volumenbereiches sich im Fokuspunkt der parabolisch geformten Fläche befindet, und
dass über Stellglieder sequentiell ein Krümmungsverhalten der parabolisch geformten Fläche und die Fokuspunktlage und somit die räumliche Lage des Volumenbereiches geändert wird.

**2.** Verfahren nach Anspruch 1,
**dadurch gekennzeichnet, dass** das stationäre magnetische Polarisationsfeld $B_0$ durch Superposition einzelner magnetischer Polarisationsfelder derart erzeugt wird, dass die einzelnen magnetischen Polarisationsfelder, die jeweils über untereinander gleichgerichtete Magnetfeldlinien verfügen, derart zueinander orientiert werden, dass sie sich in dem räumlich begrenzten Volumenbereich (4) konstruktiv zur Ausbildung der lokalen größeren magnetischen Flussdichte überlagern.

**3.** Verfahren nach Anspruch 2,
**dadurch gekennzeichnet, dass** die einzelnen Überlagerung zu bringenden magnetischen Polarisationsfelder mittels einer Array-Anordnung von elektromagnetischen Einzelmagneten in den räumlich begrenzten Volumenbereich (4) gebündelt werden, und
dass die elektromagnetischen Einzelmagnete einzeln oder gruppenweise mit elektrischer Energie versorgt werden

**4.** Verfahren nach einem der Ansprüche 1 bis 3,
**dadurch gekennzeichnet, dass** zur messtechnischen Erfassung des gesamten Objektes (O) der als Messvolumen dienende räumlich begrenzte Volumenbereich (4) iterativ innerhalb des gesamten Objektvolumens positioniert wird, und
dass durch Zusammenfügen der aus einer Vielzahl den einzelnen räumlich begrenzten Volumenbereichen zuordenbaren Messergebnissen eine Gesamtdarstellung des Objektes (O) rekonstruiert wird.

**5.** Verfahren nach einem der Ansprüche 1 bis 4,
**dadurch gekennzeichnet, dass** der räumlich begrenzte Volumenbereich durch die Superposition der Polarisationsfelder der einzelnen Magneteinheiten eine Größe von etwa 1 μl oder größer aufweist.

6. NMR-Vorrichtung mit einer ein stationäres magnetisches Polarisationsfeld $B_0$ erzeugenden Magnetanordnung (1), einer Hochfrequenzschwingkreisanordnung (6, 7) zur Erzeugung eines mit dem magnetischen Polarisationsfeld $B_0$ in Überlagerung tretenden elektromagnetischen Wechselfeldes sowie einer Empfangseinheit (8) zum Empfang von Messsignalen, die mit innerhalb des magnetischen Polarisationsfeld $B_0$ induzierten kernresonanten Prozessen korreliert sind,
wobei die Magnetanordnung (1) eine Vielzahl einzelner Magneteinheiten (2) aufweist, die derart räumlich angeordnet sind, dass sich die magnetischen Polarisationsfelder der einzelnen Magneteinheiten (2) durch Superposition zu einem magnetischen Gesamtpolarisationsfeld überlagern, in dem wenigstens ein räumlich begrenzter Volumenbereich (4) vorhanden ist, in dem eine größere magnetische Flußdichte vorherrscht als im übrigen Bereich des magnetischen Gesamtpolarisationsfeldes,
wobei die innerhalb des räumlich begrenzten Volumenbereiches (4) vorherrschende magnetische Flußdichte sowie die Frequenz des in dem räumlich begrenzten Volumenbereich (4) wirkenden elektromagnetischen Wechselfeldes aufeinander abstimmbar sind,
wobei die räumliche Lage des räumlich begrenzten Volumenbereiches (4) mit Hilfe der das stationäre magnetische Polarisationsfeld konzentrierenden Superposition bestimmbar ist und die zu dem räumlich begrenzten Volumenbereich (4) korrespondierenden Messsignale erfassbar sind und
wobei die räumliche Anordnung der Vielzahl einzelner Magneteinheiten (2) kontrolliert änderbar ist,
**dadurch gekennzeichnet, dass** die Vielzahl einzelner Magneteinheiten (2) auf der Konkavseite einer parabolisch geformten Fläche (3) angeordnet ist,
wobei die räumliche Position des Volumenbereiches sich im Fokuspunkt der parabolisch geformten Fläche befindet und
dass über Stellglieder sequentiell ein Krümmungsverhalten der parabolisch geformten Fläche (3) und die Fokuspunktlage und somit die räumliche Lage des Volumenbereiches änderbar ist.

7. NMR-Vorrichtung nach Anspruch 6,
**dadurch gekennzeichnet, dass** die Magneteinheit (2) ein Permanent- und/oder Elektromagnet ist.

8. NMR-Vorrichtung nach Anspruch 6 oder 7,
**dadurch gekennzeichnet, dass** die Magneteinheiten Elektromagnete sind, die zur Erzeugung von Magnetfelder einzeln ansteuerbar sind.

9. NMR-Vorrichtung nach Anspruch 8,
**dadurch gekennzeichnet, dass** die Elektromagnete array-förmig angeordnet sind und zur Ausbildung einer Fokuswirkung bezüglich des durch die Elektromagnete erzeugten magnetischen Polarisationsfeldes mit unterschiedlich starken Spulenströmen beaufschlagt werden.

## Claims

1. An imaging NMR method, in which an object (O) to be studied is subjected to a stationary magnetic polarization field $B_0$ and an electromagnetic alternating field and nuclear magnetic resonance processes are induced in the object (O), which are registered as measuring signals and visually displayed,
the stationary magnetic polarization field being generated by a plurality of individual magnet units,
the magnetic polarization fields of the individual magnet units being superimposed by superposition in at least one spatially delimited volume area (4) within the object (O) in such a manner that a greater magnetic flux density prevails in the spatially delimited volume area (4) than in the remaining area of the object (O),
the magnetic flux density prevailing inside the spatially delimited volume area (4) and the frequency of the electromagnetic alternating field acting in the spatially delimited volume area (4) are adapted to one another in such a manner that nuclear magnetic resonance processes are induced exclusively inside the spatially delimited volume area (4),
the spatial location of the spatially delimited volume area (4) being determined with the aid of the superposition which concentrates the stationary magnetic polarization field, and the measuring signals corresponding to the spatially delimited volume area (4) being registered,
the spatial location of the spatially delimited volume area (4) being changed in a controlled manner at least once by spatial location change of the individual magnet units and the measuring signals each being registered again from the spatially changed spatially delimited volume area (4),
**characterized in that** the individual magnet units are arranged on the concave side of a parabolically shaped surface, the spatial position of the volume area being located in the focal point of the parabolically shaped surface, and
a curvature behavior of the parabolically shaped surface and the focal point location and therefore the spatial location of the volume area are changed sequentially via actuators.

2. The method according to Claim 1,
**characterized, in that** the stationary magnetic polarization field $B_0$ is generated by superposition of individual magnetic polarization fields in such a manner that the individual magnetic polarization fields, which each have magnetic field lines oriented in the same direction with one another, are oriented to one another in such a manner that they are constructively superimposed in the spatially delimited volume area (4) to form the locally greater magnetic flux density.

3.  The method according to Claim 2, **characterized in that** the individual magnetic polarization fields to be brought into superposition are bundled in the spatially delimited volume area (4) by means of an array arrangement of electromagnetic individual magnets, and the electromagnetic individual magnets are supplied with electrical power individually or in groups.

4.  The method according to one of Claims 1 to 3, **characterized in that**, for the metrological registration of the entire object (O), the spatially delimited volume area (4) used as the measurement volume is positioned iteratively within the entire object volume, and a total representation of the object (O) is reconstructed by assembling the measurement results assignable from a plurality of the individual spatially delimited volume areas.

5.  The method according to one of Claims 1 to 4, **characterized in that** the spatially delimited volume area has a size of approximately 1 $\mu$L or greater through the superposition of the polarization fields of the individual magnet units.

6.  An NMR device having a magnet arrangement (1), which generates a stationary magnetic polarization field $B_0$, a high-frequency oscillating circuit arrangement (6, 7) for generating an electromagnetic alternating field, which is superimposed with the magnetic polarization field $B_0$, and a receiving unit (8) for receiving measuring signals, which are correlated with nuclear magnetic resonance processes induced inside the magnetic polarization field $B_0$,
the magnet arrangement (1) having a plurality of individual magnet units (2), which are spatially arranged in such a manner that the magnetic polarization fields of the individual magnet units (2) are superimposed by superposition to form a total magnetic polarization field, in which at least one spatially delimited volume area (4) is provided, in which a greater magnetic flux density prevails than in the remaining area of the total magnetic polarization field, the magnetic flux density prevailing inside the spatially delimited volume area (4) and the frequency of the electromagnetic alternating field acting in the spatially delimited volume area (4) being adaptable to one another,
the spatial location of the spatially delimited volume area (4) being determinable with the aid of the superposition, which concentrates the stationary magnetic polarization field, and the measuring signals corresponding to the spatially delimited volume area (4) being able to be registered, and
the spatial arrangement of the plurality of individual magnet units (2) being changeable in a controlled manner,
**characterized in that** the plurality of individual magnet units (2) is arranged on the concave side of a parabolically shaped surface (3), the spatial position of the volume area being located in the focal point of the parabolically shaped surface, and
a curvature behavior of the parabolically shaped surface (3) and the focal point location and therefore the spatial location of the volume area are sequentially changeable via actuators.

7.  The NMR device according to Claim 6, **characterized in that** the magnet unit (2) is a permanent magnet and/or electromagnet.

8.  The NMR device according to Claim 6 or 7, **characterized in that** the magnet units are electromagnets, which are individually activatable to generate magnetic fields.

9.  The NMR device according to Claim 8, **characterized in that** the electromagnets are arranged in the form of an array and coil currents of different strengths can be applied thereto to form a focus action with respect to the magnetic polarization field generated by the electromagnets.

## Revendications

1.  Procédé RMN fournissant des images, dans lequel un objet à examiner (O) est soumis à un champ de polarisation magnétique fixe $B_0$, ainsi qu'à un champ alternatif électromagnétique, et des processus à résonance nucléaire sont induits dans l'objet (O), lesquels sont saisis et affichés visuellement en tant que signaux de mesure,
sachant que le champ de polarisation magnétique fixe est produit par une pluralité d'unités magnétiques séparées,
que les champs de polarisation magnétiques des unités magnétiques séparées se superposent par superposition dans au moins une plage volumique limitée physiquement (4) à l'intérieur de l'objet (O), de telle sorte que dans la plage volumique limitée physiquement (4) règne une densité de flux magnétique supérieure au reste de la plage de l'objet (O), sachant que la densité de flux magnétique régnant à l'intérieur de la plage volumique limitée physiquement (4) ainsi que la fréquence du champ alternatif électromagnétique agissant dans la plage volumique limitée physiquement (4) sont ainsi accordées l'une à l'autre que des processus à résonance nucléaire sont induits exclusivement à l'intérieur de la plage volumique limitée physiquement (4),

sachant que la situation physique de la plage volumique limitée physiquement (4) est déterminée à l'aide de la superposition concentrant le champ de polarisation magnétique fixe et que les signaux de mesure correspondant à la plage volumique limitée physiquement (4) sont saisis,

sachant que la situation physique de la plage volumique limitée physiquement (4) est modifiée au moins une fois de manière contrôlée par un changement de situation physique des unités magnétiques séparées et que les signaux de mesure sont de nouveau saisis de la plage volumique limitée physiquement (4),

**caractérisé en ce que** les unités magnétiques séparées sont disposées sur le côté concave d'une face de forme parabolique, sachant que la position physique de la plage volumique se trouve dans le foyer de la face de forme parabolique, et

qu'un comportement de courbure de la face de forme parabolique et la position du foyer et ainsi la situation physique de la plage volumiques sont modifiés de manière séquentielle par des éléments de réglage.

2. Procédé selon la revendication 1,
   **caractérisé en ce que** le champ de polarisation magnétique fixe $B_0$ est ainsi produit par superposition de champs de polarisation magnétiques séparés que les champs de polarisation magnétiques qui disposent respectivement de lignes de champ magnétique redressées les unes par rapport aux autres, sont ainsi orientés l'un par rapport à l'autre qu'ils se superposent de manière constructive dans la plage volumique limitée physiquement (4) pour former la densité de flux magnétique supérieure locale.

3. Procédé selon la revendication 2,
   **caractérisé en ce que** les champs de polarisation magnétiques séparés à amener en superposition sont regroupés dans la plage volumique limitée physiquement (4) au moyen d'un agencement en rangs d'aimants électromagnétiques séparés, et que les aimants électromagnétiques séparés sont alimentés individuellement ou de manière groupée en énergie électrique.

4. Procédé selon l'une des revendications 1 à 3,
   **caractérisé en ce que** pour la saisie technique des mesures de l'ensemble de l'objet (O), la plage volumique limitée physiquement (4) servant de volume de mesure est positionnée de manière itérative à l'intérieur de l'ensemble du volume de l'objet, et que par l'ajout des résultats de mesure pouvant être attribués, d'une pluralité, aux plages volumiques limitées physiquement séparées, on reconstruit une représentation générale de l'objet (O).

5. Procédé selon l'une des revendications 1 à 4,
   **caractérisé en ce que** la plage volumique limitée physiquement présente une taille d'environ 1 $\mu$l ou plus de par la superposition des champs de polarisation des unités magnétiques séparées.

6. Dispositif RMN comprenant un agencement d'aimants (1) produisant un champ de polarisation magnétique fixe $B_0$, un agencement de circuit oscillant haute fréquence (6, 7) pour produire un champ alternatif électromagnétique entrant en superposition avec le champ de polarisation magnétique fixe $B_0$, ainsi qu'une unité de réception (8) pour recevoir des signaux de mesure, qui sont corrélés avec des processus à résonance nucléaire induits à l'intérieur du champ de polarisation magnétique fixe $B_0$,

   sachant que l'agencement d'aimants (1) présente une pluralité d'unités magnétiques séparées (2), qui sont ainsi disposées physiquement que les champs de polarisation magnétiques des unités magnétiques séparées (2) se superposent par superposition en un champ de polarisation magnétique global, dans lequel au moins une plage volumique limitée physiquement (4) est présente, à l'intérieur de laquelle règne une densité de flux magnétique supérieure au reste de la plage du champ de polarisation magnétique global,

   sachant que la densité de flux magnétique régnant à l'intérieur de la plage volumique limitée physiquement (4) ainsi que la fréquence du champ alternatif électromagnétique agissant dans la plage volumique limitée physiquement (4) peuvent être accordées l'une à l'autre,

   sachant que la situation physique de la plage volumique limitée physiquement (4) est déterminée à l'aide de la superposition concentrant le champ de polarisation magnétique fixe et les signaux de mesure correspondant à la plage volumique limitée physiquement (4) peuvent être saisis, et

   sachant que l'agencement physique de la pluralité d'unités magnétiques séparées (2) peut être modifié de manière contrôlée,

   **caractérisé en ce que** la pluralité d'unités magnétiques séparées (2) sont disposées sur le côté concave d'une face (3) de forme parabolique, sachant que la position physique de la plage volumique se trouve dans le foyer de la face de forme parabolique, et qu'un comportement de courbure de la face (3) de forme parabolique et la position du foyer et ainsi la situation physique de la plage volumiques sont modifiés de manière séquentielle par des éléments de réglage.

7. Dispositif RMN selon la revendication 6,
   **caractérisé en ce que** l'unité magnétique (2) est un aimant permanent et/ou un électroaimant.

8. Dispositif RMN selon la revendication 6 ou 7,

**caractérisé en ce que** les unités magnétiques sont des électroaimants qui peuvent être commandés individuellement pour produire des champs magnétiques.

9. Dispositif RMN selon la revendication 8, **caractérisé en ce que** les électroaimants sont disposés en rangs et sont alimentés avec des courants de bobine de force différente pour former un effet de focalisation par rapport au champ de polarisation magnétique produit par les électroaimants.

**Fig. 1**

**Fig. 2**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19939626 A1
- DE 3639140 A1
- EP 0228154 A2
- US 6281775 B1
- WO 003479 A
- EP 0927889 A2

**In der Beschreibung aufgeführte Nicht-Patentliteratur**

- **VON M.J.D. MALLETT et al.** Stray Field Imaging by Magnetic Field Sweep. *J.Mag.Res.,* 1998, vol. 132, 172-175